Europäisches Patentamt

**European Patent Office**

Office européen des brevets

(19)

(11) Veröffentlichungsnummer: **0 135 139**
A2

(12) **EUROPÄISCHE PATENTANMELDUNG**

(21) Anmeldenummer: **84109643.1**

(22) Anmeldetag: **13.08.84**

(51) Int. Cl.⁴: **H 03 K 3/288**

(30) Priorität: **19.08.83 DE 3330079**

(43) Veröffentlichungstag der Anmeldung:
**27.03.85 Patentblatt 85/13**

(84) Benannte Vertragsstaaten:
**AT DE FR GB IT NL**

(71) Anmelder: **Siemens Aktiengesellschaft**
**Berlin und München Wittelsbacherplatz 2**
**D-8000 München 2(DE)**

(72) Erfinder: **Schmitt-Landsiedel, Doris Dipl.-Ing.,**
**Dipl.-Phys.**
**Metzstrasse 25**
**D-8000 München 80(DE)**

(72) Erfinder: **Dorda, Gerhard, Dr.**
**Triester Strasse 11**
**D-8000 München 80(DE)**

(54) **Integrierte JK-Flipflop-Schaltung.**

(57) Integrierte JK-Flipflop-Schaltung mit zwei kreuzgekoppelten Invertern, die jeweils aus einem Transistor (T1, T2) und einem zu diesem in Serie geschalteten Widerstandselement (R1, R2) bestehen. Zusätzliche Schaltelemente verbinden die Flipflopeingänge mit den kreuzgekoppelten Invertern. Angestrebt wird die Realisierung der Flipflop-Schaltung auf einer möglichst kleinen Halbleiterfläche. Das wird dadurch erreicht, daß die Transistoren (T1, T2) der Inverter als Heiße-Elektronen-Transistoren ausgebildet sind, wobei jeder von ihnen mit einem der zusätzlichen Schaltelemente, das als Feldeffekttransistor realisiert ist, zu einem gemeinsamen Bauelement zusammengefaßt ist, das zwei Transistorfunktionen übernimmt, aber nur die Fläche eines Feldeffekttransistors benötigt. Der Anwendungsbereich umfaßt hochintegrierte Schaltkreise.

FIG 1

SIEMENS AKTIENGESELLSCHAFT
Berlin und München

Unser Zeichen
VPA 83 P 1612 E

Integrierte JK-Flipflop-Schaltung

Die Erfindung bezieht sich auf eine integrierte JK-Flipflop-Schaltung nach dem Oberbegriff des Patentanspruchs 1.

Eine Flipflop-Schaltung dieser Art ist aus dem Buch "Mikroelektronische Schaltkreise" von A. Möschwitzer und G. Jorke, VEB Verlag Technik, Berlin, 1979, S. 121, Bild 2.41d, bekannt. Die zusätzlichen Schaltelemente sind hier als Feldeffekttransistoren realisiert, wobei zwei von ihnen den Feldeffekttransistoren der kreuzgekoppelten Inverter mit ihren Source-Drain-Strecken parallel geschaltet sind.

Der Erfindung liegt die Aufgabe zugrunde, eine integrierte JK-Flipflop-Schaltung anzugeben, die auf einer wesentlich kleineren Halbleiterfläche realisiert werden kann, als vergleichbare herkömmliche Schaltungen. Erfindungsgemäß wird dies durch eine Ausbildung nach dem kennzeichnenden Teil des Patentanspruchs 1 erreicht.

Der mit der Erfindung erzielbare Vorteil besteht insbesondere darin, daß jeweils zwei Feldeffekttransistoren der bekannten JK-Flipflop-Schaltung zu einem einzigen Halbleiterbauelement zusammengefaßt werden, das zwei Transistorfunktionen übernimmt und zur Realisierung lediglich die Halbleiterfläche eines einzigen MIS-Feld-effekttransistors benötigt. Die Schaltgeschwindigkeit des erfindungsgemäßen Flipflops ist gegenüber herkömmlichen Schaltungen stark erhöht, da die in den Halb-leiterbauelementen vorhandenen HET-Transistoren schnell-

St 1 Sti/17.8.83 schaltende Elemente darstellen und die Verbindungsleitungen zwischen den jeweils zu solchen Bauelementen zusammengefaßten Transistoren entfallen.

Die Ansprüche 2 bis 11 sind auf bevorzugte Ausgestaltungen und Weiterbildungen der Erfindung gerichtet.

Nachfolgend wird die Erfindung anhand der Zeichnungen
näher erläutert. Dabei zeigt:

Fig. 1 ein erfindungsgemäß ausgebildetes JK-Flipflop,

Fig. 2 den Querschnitt eines in Fig. 1 schematisch dargestellten Bauelements, das einen MIS-Feldeffekttransistor und einen Heiße-Elektronen-Transistor
aufweist,

Fig. 3 ein Bandstrukturschema zur Erläuterung von Fig. 2
und

Fig. 4 ein weiteres erfindungsgemäß ausgebildetes JK-
Flipflop.

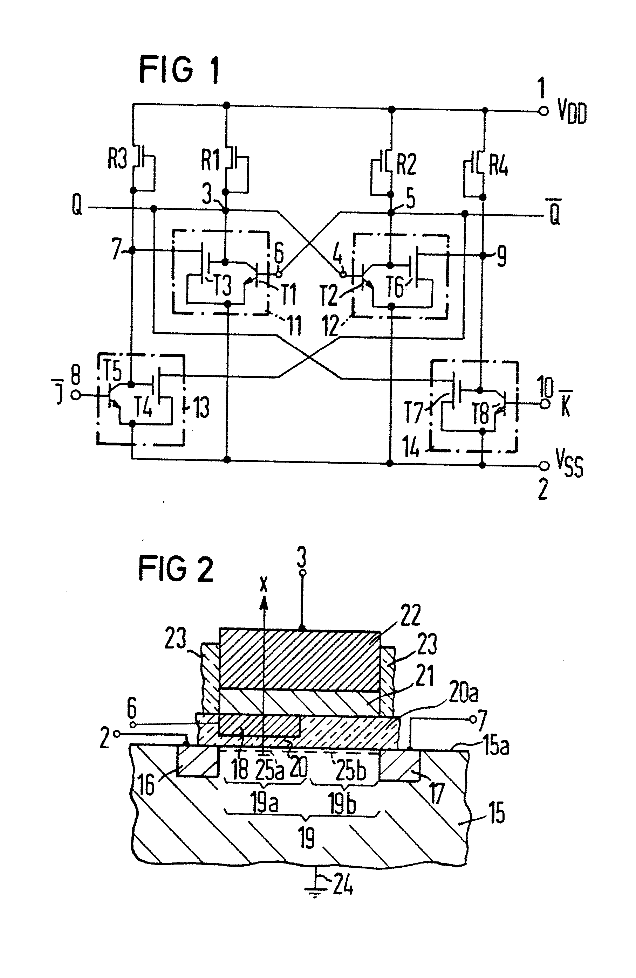

In Fig. 1 sind zwei kreuzgekoppelte Inverter dargestellt,
die eine Flipflop-Schaltung bilden. Der erste Inverter
besteht aus der Serienschaltung eines Transistors T1 und
eines Widerstandselements R1, wobei die endseitigen Anschlüsse 1 und 2 der Serienschaltung jeweils mit der
Versorgungsspannung $V_{DD}$ und dem Bezugspotential $V_{DD}$ beschaltet sind. Der zweite Inverter, der einen Transistor
T2 und ein Widerstandselement R2 umfaßt, liegen ebenfalls an den Anschlüssen 1, 2. Zwischen T1 und R1 befindet
sich ein Schaltungsknoten 3, der mit dem Basisanschluß 4
von T2 verbunden ist, zwischen T2 und R2 ein Schaltungsknoten 5, der an den Basisanschluß 6 von T1 geführt ist.

Die Widerstandselemente R1 und R2, die in Fig. 1 als Feldeffekttransistoren des Verarmungstyps dargestellt sind, deren Gateelektroden mit den Sourceanschlüssen verbunden sind, können auch in anderer Weise realisiert werden, so z.B. als Feldeffekttransistoren des Anreicherungstyps, deren Gateelektroden mit den Drainanschlüssen verbunden sind, als streifenförmige Strukturen aus widerstandsbehaftetem Material oder dgl.. Die Schaltungsknoten 3 und 5 stellen gleichzeitig den Ausgang $\overline{Q}$ und den inversen Ausgang der Flipflop-Schaltung dar.

An den Anschlüssen 1 und 2 liegt weiterhin die Serienschaltung eines Feldeffekttransistors T3 und eines Widerstandselements R3, wobei das Gate von T3 mit dem Schaltungsknoten 3 verbunden ist, während der Verbindungspunkt 7 von T3 und R3 an das Gate eines Feldeffekttransistors T4 geführt ist, dessen Source-Drain-Strecke zwischen den Schaltungspunkten 2 und 5 liegt. Zwischen die Schaltungspunkte 7 und 2 ist die Kollektor-Emitter-Strecke eines weiteren Transistors T5 geschaltet, dessen Basisanschluß 8 den Steuereingang $\overline{J}$ des JK-Flipflops darstellt. Das bedeutet, daß dem Anschluß 8 stets das invertierte J-Signal zugeführt wird.

In analoger Weise liegt noch eine Serienschaltung eines Feldeffekttransistors T6 und eines Widerstandselements R4 zwischen den Anschlüssen 1 und 2, wobei das Gate von T6 mit dem Schaltungsknoten 5 verbunden ist, während der Verbindungspunkt von T6 und R4 an das Gate eines Feldeffekttransistors T7 geführt ist, dessen Source-Drain-Strecke mit den Schaltungspunkten 2 und 3 verbunden ist. Zwischen die Schaltungspunkte 9 und 2 ist schließlich die Kollektor-Emitter-Strecke eines Transistors T8 eingefügt, dessen Basisanschluß 10 den Steuereingang $\overline{K}$

des Flipflops bildet. Das bedeutet, daß dem Anschluß 10 stets das invertierte K-Signal zugeführt wird.

Die Transistoren T1, T2, T5 und T8 sind als Heiße-Elektronen-Transistoren des Tunnelemissionstyps realisiert. Transistoren dieser Art sind z.B. aus Solid-State Electronics, Bd. 24, 1981, S. 343 - 366, insbesondere Fig.1, bekannt. Nach der Erfindung ist jeder dieser Heiße-Elektronen-Transistoren mit einem Feldeffekttransistor der Flipflopschaltung zu einem gemeinsamen Bauelement zusammengefaßt, und zwar T1 und T3 zu einem Bauelement 11, T2 und T6 zu einem Bauelement 12, T5 und T4 zu einem Bauelement 13 und T8 und T7 zu einem Bauelement 14.

Diese Bauelemente, die untereinander gleich ausgebildet sind, werden im folgenden anhand des Bauelements 11 näher beschrieben. Dabei zeigt Fig. 2 einen Querschnitt durch dieses Bauelement.

Es ist auf einem Körper 15 aus dotiertem Halbleitermaterial, z. B. p-dotiertem Silizium mit einer Störstellenkonzentration von etwa $10^{15}/cm^3$, angeordnet, in den zwei von einer Grenzfläche 15a ausgehende, z.B. n+-dotierte Gebiete 16 und 17 eingefügt sind. Diese stellen das Sourcegebiet und das Draingebiet des Feldeffekttransistors T 3 dar, dessen Gateelektrode aus zwei Teilen besteht. Der erste Teil wid von einer metallischen bzw. metallisch leitenden Schicht 18 gebildet, die den an das Gebiet 16 grenzenden Teil 19a des zwischen 16 und 17 liegenden Kanalbereichs 19 überdeckt. Zwischen der Schicht 18 und der Grenzfläche 15a liegt dabei eine sehr dünne Isolatorschicht 20. Die Dicke der z.B. aus $SiO_2$ oder $Si_3N_4$ bestehenden Isolatorschicht 20 beträgt zweckmäßigerweise etwa 2 bis 5 nm. Die Schicht 18 besteht mit Vorteil aus einem hochschmelzenden Metall, z.B. aus Ta, Ti oder Mo oder W, oder aus dem Silizid
eines dieser Metalle. d.h. aus $TaSi_2$, $TiSi_2$, $MoSi_2$ oder
$WSi_2$, und kann eine Dicke von etwa 10 nm aufweisen.
Oberhalb der Schicht 18 befindet sich eine polykristalline Siliziumschicht mit einer Dicke von etwa 10
bis 100 nm und vorzugsweise mit einer p-Dotierung, die
etwa durch eine Dotierungskonzentration von $10^{14}$ bis
$10^{15}/cm^3$ gegeben ist, wobei als Dotierstoff Bor herangezogen werden kann. Auf der Schicht 21 befindet sich
eine metallische bzw. metallisch leitende Schicht 22,
deren Dicke beliebig gewählt sein kann, zweckmäßigerweise jedoch größer ist als die Schichtdicke von 21. Die
Schicht 22 besteht dabei mit Vorteil aus einem der Metalle oder Silizide, die bereits im Zusammenhang mit der
Schicht 18 genannt worden ist. Die Schichten 21 und 22
überdecken den gesamten Kanalbereich 19, wobei derjenige Teil von 22, der die Schicht 18 lateral überragt, den
zweiten Teil 19b des Kanalbereichs 19 überdeckt. Eine
die Oberfläche 15a außerhalb der Teile 16, 17 und 19
abdeckende elektrisch isolierende Schicht (Feldoxidschicht) weist an die Schichten 18, 21 und 22 lateral
angrenzende Teile 23 auf.

Das Sourcegebiet 16 ist mit dem Anschluß 2 verbunden,
das Draingebiet 17 mit dem Schaltungspunkt 7. Der Halbleiterkörper 15 ist bei 24 mit dem Bezugspotential beschaltet. Ferner ist die Basisschicht 18 mit dem Anschluß 66 verbunden, während die Schicht 22 mit dem
Schaltungsknoten 3 beschaltet ist.

Erhält der aus der Schicht 18 bestehende Teil der Gateelektrode des Feldeffekttransistors T1 über den Anschluß 6 eine Spannung zugeführt, die oberhalb eines als
erste Einsatzspannung bezeichneten Wertes liegt, so bildet sich im Halbleiterkörper 15 unterhalb von 18 eine
von der Grenzfläche 15a ausgehende Verarmungszone aus,

0135139

wobei sich innerhalb dieser Verarmungszone unmittelbar an der Grenzfläche 15a eine Inversionsschicht 25a aufbaut, die einen n-leitenden Kanal unterhalb von 18 bildet. Die Inversionsschicht 25a stellt die Emitterschicht eines Heiße-Elektronen-Transistors (HET) des Tunnelemissionstyps dar, der zusätzlich die Schichten 20, 18, 21 und 22 aufweist. Dabei bildet die Schicht 18 eine metallische bzw. metallisch leitende Basisschicht des HET, wobei sich die Isolatorschicht 20 zwischen der Schicht 18 und der Emitterschicht 25a befindet, während die polykristalline Siliziumschicht 21 zusammen mit der metallischen bzw. metallisch leitenden Schicht 22 die Kollektorschciht des HET darstellt. Über den Anschluß 3 wird der Schicht 22 eine Kollektorspannung zugeführt, die in Fig. 1 aus der Spannung am Schaltungsknoten 3 besteht. Übersteigt diese Spannung eine zweite Einsatzspannung, die dem Teil 19b des Kanalbereichs 19 zugeordnet ist, so bildet sich unterhalb von dem die Schicht 18 lateral überragenden Teil der Schicht 22 eine Inversionsschicht 25b aus, die zusammen mit der Inversionsschicht 25a einen n-leitnden Kanal zwischen den Gebieten 16 und 17 bilden. Daß sich ein Teil 20a der Isoltorschicht 20, der mit z.B. 15 nm wesentlich dicker ist als die übrigen Teile dieser Schicht, zwischen dem zweiten von der Schicht 22 gebildeten Teil der Gateelektrode und dem Teil 19b des Kanalbereichs 19 befindet, ist mitbestimmend dafür, daß die zweite Einsatzspannung höher is als die erste.

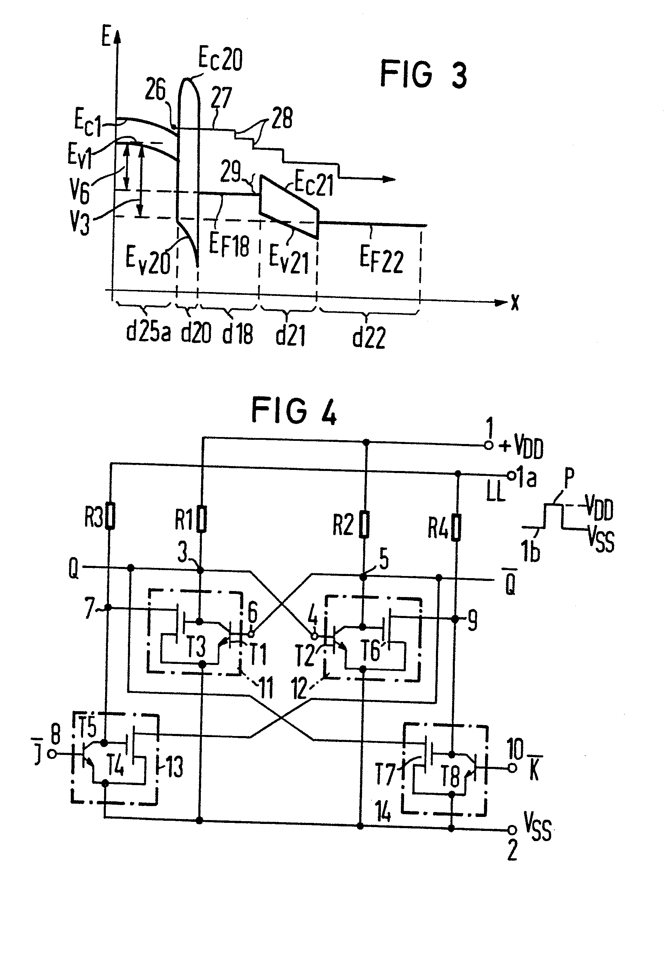

Die Funktion des HET sei nachfolgend anhand des in Fig. 3 dargestellten energetischen Bandstrukturschemas erläutert. Dieses zeigt in Richtung der vertikalen Achse aufgetragene Energiezustände E, die in Abhängigkeit von verschiedenen Entfernungen x von der Inversionsschicht bzw. Emitterschicht 25a auftreten. Diese Entfernungen sind auf der Achse x aufgetragen, die in Fig. 2 die Schichten des HET in vertikaler Richtung, d.h. senkrecht zur Grenzfläche 15a, durchdringt. Den Schichten 25a, 20, 18, 21 und 22 sind aufeinanderfolgende Abschnitte der x-Achse zugeordnet, wobei aus Gründen einer deutlichen Darstellung die Längen d25a, d20, d18, d21 und d22 dieser Abschnitte von den tatsächlichen Schichtdicken D25a, D20, D18, D21 und D22 der Schichten 25a, 20, 18, 21 und 22 abweichen. So ist z.B. der Abschnitt d20 gegenüber den Abschnitten d25a, d18, d21 und d22 stark gedehnt. In dem der Inversionsschicht 25a zugeordneten Abschnitt d25a ist die obere Grenze des Valenzbandes des Halbleitermaterials von 15 mit $E_{v1}$ bezeichnet, während $E_{c1}$ das Energieniveau der Elektronen innerhalb der Inversionsschicht 25a darstellt. Im Abschnitt d20 stellt die obere Linie $E_{c20}$ die untere Begrenzung des Leitungsbandes der Isolatorschicht 20 dar, während die untere Linie $E_{v20}$ die obere Grenze des Valenzbandes bedeutet. In den Abschnitten d18 und d22 sind die jeweiligen Fermi-Niveaus $E_{F18}$ und $E_{F22}$ eingetragen, während im Abschnitt d21 die untere Grenze des Leitungsbandes der Schicht 21 durch $E_{c21}$ und die obere Grenze des Valenzbandes durch $E_{v21}$ dargestellt werden.

Bei einer hinreichend kleinen Dicke D20 der Isolatorschicht 20 gelangen Elektronen aus der Inversionsschicht 25a, die in Fig. 3 gemäß ihrem Energieniveau z.B. durch den Punkt 26 gekennzeichnet sind, infolge des Tunneleffekts durch die Isolatorschicht 20 in die Basisschicht 18, wie durch die horizontale Gerade angedeutet wird. Durch Streuung an Fehlstellen und am Kristallgitter der Schicht 18 verlieren sie an Energie, was durch den treppenförmigen Verlauf 28 ausgedrückt wird. Ist die Energie dieser Elektronen danach noch so groß, daß sie die Energieschwelle 29 an der Grenzfläche zwischen den Schichten 18 und 21 überwinden können, so gelangen sie in die aus den Schichten 21 und 22 bestehende Kollektorschicht des HET. Die Größen der über die Anschlüsse 6 und 3 gegenüber dem Bezugspotential angelegten
Spannungen sind in Fig. 3 mit $V_6$ und $V_3$ bezeichnet.

Befindet sich das JK-Flipflop im rückgesetzten Zustand
(T1 leitet, T2 sperrt), so ist am Ausgang $\overline{Q}$ eine etwa
der Versorgungsspannung $V_{DD}$ entsprechende Spannung abgreifbar, die einer logischen "1" entspricht. Während
der Ausgang Q etwa auf Bezugspotential $V_{SS}$ liegt, was
einer logischen "0" entspricht. Als Folge des niedrigen
Potentials an 3 wird die zweite Einsatzspannung von T3
unterschritten, so daß sich die Inversionsschicht 25b
dieses Transistors nicht ausbilden kann und seine
Gebiete 16 und 17 keine leitende Verbindung aufweisen.
Daher sperrt T3, obwohl seine Inversionsschicht 25a
wegen der "1" an $\overline{Q}$ und damit an der Basisschicht 18 von
T1 vorhanden ist. Andererseits leitet T6 wegen der am
Ausgang $\overline{Q}$ liegenden "1", mit der die erste und zweite
Einsatzspannung von T6 überschritten wird, obwohl der
Basisschicht 18 von T2 über den Anschluß 4 eine "0"
zugeführt wird.

Trotz des gesperrten Transistors T3 befindet sich der
Schaltungspunkt 7 etwa auf Bezugspotential $V_{SS}$, weil T5
im Ausgangszustand der Schaltung, in dem der Eingang 8
mit einer logischen "1" belegt ist, leitet. Der Schaltungspunkt 9 ist andererseits sowohl über den leitenden
Transistor T6 als auch über den leitenden Transistor T8,
dem im Ausgangszustand der Schaltung über 10 ebenfalls
ständig eine logische "1" zugeführt wird, etwa auf das
Bezugspotential $V_{SS}$ gelegt. Daher sind die Transistoren
T4 und T7 gesperrt, so daß über sie keine Beeinflussung
des Schaltzustandes des Flipflops erfolgen kann. Dabei
sind in den Bauelementen 13 und 14 die Inversionsschichten 25a von T4 und T7 jeweils vorhanden, während ihre Inversionsschichten 25b fehlen.

Führt man eine logische "1" als J-Signal kurzzeitig zu, was am invertierenden Eingang 8 eine kurzzeitige Umschaltung von der ständig anliegenden "1" auf eine "0" bedeutet, so wird für die kurze Dauer der Umschaltung T5 gesperrt, das Potential des Schaltungspunktes 7 auf etwa $V_{DD}$ angehoben, T4 durch Ausbildung der Inversionsschicht 25b in den leitenden Zustand geschaltet und $\overline{Q}$ über T4 auf das Potential $V_{SS}$ heruntergezogen, wobei diese Potentialabsenkung, die sich auch am Anschluß 6 bemerkbar macht, T1 sperrt. Damit steigt die Spannung am Ausgang Q auf eine "1", so daß T2 leitet. Damit ist das Flipflop in den gesetzten Zustand geschaltet (T1 sperrt, T2 leitet). Wegen der leitenden Transistoren T3 und T5 liegt 7 auf dem Bezugspotential $V_{SS}$, während 9 trotz des gesperrten Transistors T6 wegen des leitenden Transistors T8 ebenfalls auf $V_{SS}$ gehalten wird. Die Potentiale an 7 und 9 sperren somit T4 und T7, so daß eine weitere Beeinflussung der Flipflopschaltung unterbleibt.

Erst bei Zuführung eines kurzzeitigen K-Signals, d.h. bei einer kurzzeitigen Umschaltung am Anschluß 10 von der ständig anliegenden "1" auf eine "0", wird für die Dauer dieser Umschaltung T8 gesperrt, das Potential an 9 etwa auf den Wert $V_{DD}$ angehoben, T7 hierdurch leitend geschaltet und über diesen der Ausgang Q wieder auf $V_{SS}$ bzw. "0" gelegt, was über die Kreuzkopplung der Inverter T1, R1 und T2, R2 eine Leitendschaltung von T2 bewirkt. Damit ist das Flipflop wieder in den rückgesetzten Zustand übergegangen.

Führt man schließlich kurzzeitig J- und K-Signale gleichzeitig der Schaltung zu, was eine gleichzeitige kurze Umschaltung der an 8 und 10 ständig anliegenden "1"-Signale auf "0"-Signale bedeutet, so wird bei jeder solchen Umschaltung das Flipflop vom gesetzten Zustand
in den rückgesetzten oder umgekehrt geschaltet. Am
Ausgang Q ist hierbei eine Folge von "1"-Signalen abgreifbar, die die halbe Folgefrequenz der Signale
an 8 oder 10 aufweist.

Fig. 4 zeigt ein zweites Ausführungsbeispiel einer nach
der Erfindung ausgebildeten, getakteten JK-Flipflop-
Schaltung. Diese unterscheidet sich von Fig. 1 dadurch,
daß nur die beiden Serienschaltungen T1, R1 und T2, R2
mit den Anschlüssen 1 und 2 verbunden sind. Die Serienschaltungen T3, R3 und T6, R4 sind zum Unterschied von
Fig. 1 mit einem Anschluß 1a verbunden, der mit einem
Taktsignal 1b beschaltet ist. Das Taktsignal alterniert
zwischen den Werten $V_{SS}$ und $V_{DD}$, wobei letzterer nur
während des Auftretens der kurzzeitigen Taktimpulse P
erreicht wird. Befindet sich die Flipflopschaltung nach
Fig. 4 im rückgesetzten Zustand (Q = 0), so bewirkt eine
dem Eingang 8 zugeführte "0" die dem Signal J = 1 entspricht, beim Auftreten des jeweils nächstfolgenden
Taktimpulses P eine Umschaltung in den gesetzten Zustand. Liegt dieser vor, so bewirkt andererseits eine
dem Eingang 8 zugeführte "0", die einem Signal K = 1
entspricht, beim Auftreten des jeweils nächstfolgenden
Taktimpulses P eine Umschaltung in den rückgesetzten
Zustand. Liegt an beiden Eingängen 8 und 10 jeweils eine
"1", so wird der Schaltzustand des Flipflops beim
Auftreten jeden Taktimpulses P geändert. Dabei ist an
einem der Ausgänge, z.B. Q, eine Impulsfolge abgreifbar,
die die halbe Folgefrequenz der Taktimpulse P aufweist.

Die Herstellung des Halbleiterbauelements nach Fig. 2
entspricht zunächst der üblichen Herstellung eines Feldeffekttransistors. Nachdem eine den Halbleiterkörper 15
ganzflächig bedeckende Feldoxidschicht 23 oberhalb des
Kanalbereichs 19 und der Gebiete 16 und 17 weggeätzt und in dem weggeätzten Bereich eine Isolatorschicht mit einer Dicke von z.B. 15 nm aufgewachsen wurde, was etwa der Dicke des Teils 20a in Fig. 2 entspricht, wird eine Zwischenmaske auf der Isoltorschicht 20a angebracht, die mit ihrer Öffnung lediglich den Bereich der metallisch leitenden Schicht 15 freiläßt. In diesem Bereich wird die Isolatorschicht, z.B. durch ein Ätzmittel auf Fluor-Wasserstoff-Basis, auf eine Dicke von etwa 2 bis 5 nm abgeätzt, was in Fig. 2 durch die reduzierte Dicke der Schicht 20 oberhalb von 19a angedeutet ist. Unter Verwendung derselben Zwischenmaske wird dann die Schicht 18 aufgebracht. Nach dem Entfernen der Zwischenmaske wird eine weitere Maske angebracht, die eine die lateralen Abmessungen der Schichten 21 und 22 definierende Öffnung enthält. Unter Anwendung dieser Maske werden dann die Schichten 21 und 22 nacheinander aufgebracht. Dabei wird die Schicht 21 mit einer p-Dotierung versehen, deren Konzentration $10^{14}$ bis $10^{15}/cm^3$ beträgt, bevor die Schicht 22 aufgebracht wird. Nach dem Entfernen der Maske erfolgt eine Implantation eines Dotierstoffes zur Erzeugung der Gebiete 16 und 17, wobei die Schichten 18, 21 und 22 sowie die Feldoxidschicht als Teile einer Dotierungsmaske dienen (Selbstjustierung). Nach dem Anbringen von Anschlußleitungen,-die zu den Schaltungspunkten 2 und 7 führen und die die Teile 16 und 17 durch Kontaktlöcher in der Isolatorschicht 20a kontaktieren, werden oberhalb der Gebiete 16 und 17 die vorher weggeätzten Teile der Feldoxidschicht wieder so weit aufgebaut, daß die Feldoxidschicht an die lateralen Begrenzungsflächen der Schichten 18, 21 und 22 heranreicht, wie das in Fig. 2 durch die Teile 23 angedeutet ist. Danach wird eine die Schicht 22 kontaktierende Anschlußleitung verlegt, die zum Anschluß 3 führt.

Nach einer anderen bevorzugten Ausführungsform der Erfingund ist das Halbleiterbauelement 11, 12, 13 oder 14

**0135139**

auf einem Körper 15 aus einer p-dotierten III-V-Halbleiterverbindung, z.B. GaAs mit einer Dotierungskonzentration von z.B. $10^{16}/cm^3$, aufgebaut, wobei die Isolatorschicht 20 zweckmäßigerweise aus AlGaAs besteht. An die Stelle der polykrisitallinen Siliziumschicht 21 tritt hier ene Schicht aus p-dotiertem GaAs mit Be als Dotierstoff, während die Schicht 18 vorzugsweise aus einer hochdotierten n-leitenden III-V-Halbleiterverbindung, z.B. GaAs mit Si als Dotierstoff, gebildet wird, die sich bei einer Dotierungskonzentration von etwa $10^{18}/cm^3$ hinsichtlich ihrer elektrischen Leitfähigkeit ähnlich wie ein Metall verhält. Die Schicht 22 besteht auch hierbei mit Vorteil aus dem gleichen Material wie die Schicht 18.

Bei einer weiteren Ausführungsform der Erfindung ist das Halbleiter-Bauelement 11, 12, 13 oder 14 so ausgebildet, daß an die Stelle der bisher beschriebenen Schicht 21 eine zweite Isolatorschicht tritt, die in ihrem Aufbau und in ihrer Dicke vorzugsweise der Isolatorschicht 20 entspricht. Für den Fall, daß ein Halbleiterkörper 15 aus p-dotiertem Silizium vorgesehen ist, besteht die zweite Isolatorschicht aus $SiO_2$ oder $Si_3N_4$. Bei einem Halbleiterkörper aus GaAs besteht sie aus AlGaAs. Ihre Dicke beträgt zweckmäßigerweise etwa 2 bis 5 nm.

11 Patentansprüche
4 Figuren

Patentansprüche

1. Integrierte JK-Flipflop-Schaltung mit zwei kreuzgekoppelten Invertern, die jeweils aus einem Transistor (T1, T2) und einem zu diesem in Serie geschalteten Widerstandselement (R1, R2) bestehen, wobei
jeweils der Schaltungsknoten (3) zwischen dem Transistor
(T1) und dem Widerstandselement (R1) des einen Inverters
mit dem Steueranschluß (4) des Transistors (T2) des
anderen Inverters verbunden ist, wobei jeweils der eine
Schaltungsknoten (3) über einen weiteren Inverter (T3,
R3) mit dem Gate eines ersten Feldeffekttransistors (T4)
beschaltet ist, der mit seiner Source-Drain-Strecke
zwischen den anderen Schaltungsknoten (5) und einen auf
Bezugspotential liegenden Anschluß (2) geschaltet ist,
und wobei das Gate dieses Feldeffekttransistors (T4) mit
dem Anschluß (2) über ein zusätzliches Schaltelement
(T5) verbunden ist, dessen Steuereingang jeweils einen
Flipflop-Eingang darstellt, d a d u r c h   g e -
k e n n z e i c h n e t ,  daß die Transistoren (T1, T2)
der kreuzgekoppelten Inverter jeweils aus einem Heiße-
Elektronen-Transistor des Tunnelemissionstyps bestehen,
der eine Emitterschicht, eine Isolatorschicht, eine
Basisschicht und eine Kollektorschicht aufweist, daß
jeder Heiße-Elektronen-Transistor (T1) eines der kreuzgekoppelten Inverter mit dem an einem zweiten Feldeffekttransistor (T3) bestehenden Schaltelement eines
der weiteren Inverter derart zusammengefaßt ist, daß die
Emitterschicht aus einer Inversionsschicht (25a) im
Kanalbereich des zweiten Feldeffekttransistors (T3)
besteht, daß die Basisschicht (18) einen ersten Teil der
Gateelektrode darstellt, daß die Isolatorschicht (20)
zwischen der Basisschicht (18) und einem ersten Teil des
Kanalbereichs (19) angeordnet ist und daß die

**0135139**

Kollektorschicht mit einem die Basisschicht (18) lateral überragenden Teil (22) den restlichen Teil der Gateelektrode darstellt, der den restlichen Teil des Kanalbereichs (19) überdeckt.

2. Integrierte JK-Flipflop-Schaltung nach Anspruch 1, d a d u r c h   g e k e n n z e i c h n e t , daß jeder der als zusätzliche Schaltelemente (T5, T8) dienenden Heiße-Elektronen-Transistoren mit einem der ersten Feldeffekttransistoren (T4) derart zusammengefaßt ist, daß die Emitterschicht aus einer Inversionsschicht (25a) im Kanalbereich dieses Feldeffekttransistors (T4) besteht, daß die Basisschicht (18) einen ersten Teil der Gateelektrode darstellt, daß die Isolatorschicht (29) zwischen der Basisschicht (18) und einem ersten Teil des Kanalbereichs (19) angeordnet ist und daß die Kollektorschicht mit einem die Basisschicht (18) lateral überragenden Teil (22) den restlichen Teil des Kanalbereichs (19) überdeckt.

3. Integrierte JK-Flipflop-Schaltung nach einem der Ansprüche 1 oder 2, d a d u r c h   g e k e n n - z e i c h n e t ,  daß die weiteren Inverter (T3, R3; T6, R4) zwischen einen mit einem Taktsignal (1b) beschalteten ersten Anschluß (1a) und einen auf Bezugspotential ($V_{SS}$) liegenden zweiten Anschluß (2) geschaltet sind, während die kreuzgekoppelten Inverter (T1, R1; T2, R2) zwischen einen dritten, mit der Versorgungsspannung beschalteten Anschluß (1) und den zweiten Anschluß (2) geschaltet sind.

4. Integrierte JK-Flipflop-Schaltung nach einem der Ansprüche 1 bis 3, d a d u r c h   g e k e n n - z e i c h n e t ,  daß die Basisschicht (18) aus einem Metall besteht, das insbesondere einer Gruppe von hochschmelzenden Metallen angehört, in der Ta, Ti, Mo und W enthalten sind, oder aus einem Silizid eines solchen Metalls.

5. Integrierte JK-Flipflop-Schaltung nach einem der Ansprüche 1 bis 3, d a d u r c h g e k e n n - z e i c h n e t , daß die Basisschicht (18) aus einer hochdotierten III-V-Halbleiterverbindung, wie z.B. GaAs, besteht, die mit einer n-Dotierung versehen ist.

6. Integrierte JK-Flipflop-Schaltung nach einem der Ansprüche 1 bis 3, d a d u r c h g e k e n n - z e i c h n e t , daß die Kollektorschicht aus einer metallischen oder metallisch leitenden Schicht (22) und einer zwischen dieser und der Basisschicht (18) befindlichen, polykristallinen, vorzugsweise mit einer p-Dotierung versehenen, Siliziumschicht (21) besteht.

7. Integrierte JK-Flipflop-Schaltung nach einem der Ansprüche 1 bis 3, d a d u r c h g e k e n n - z e i c h n e t , daß die Kollektorschicht aus einer metallischen oder metallisch leitenden Schicht (22) und einer zwischen dieser und der Basisschicht (18) befindlichen Schicht (21) aus einer III-V-Halbleiterverbindung, wie z.B. GaAs, besteht, die vorzugsweise mit einer p-Dotierung versehen ist.

8. Integrierte JK-Flipflop-Schaltung nach einem der Ansprüche 1 bis 3, d a d u r c h g e k e n n - z e i c h n e t , daß die Kollektorschicht aus einer metallischen oder metallisch leitenden Schicht (22) und einer zwischen dieser und der Basisschicht (18) befindlichen, zweiten Isolatorschicht (21) besteht.

9. Integrierte JK-Flipflop-Schaltung nach einem der Ansprüche 6 bis 8, d a d u r c h g e k e n n - z e i c h n e t , daß die einen Teil der Kollektorschicht darstellende metallische oder metallisch leitende Schicht (22) aus einem Metall besteht, das insbesondere einer Gruppe von hochschmelzenden Metallen angehört, in der Ta, Ti, Mo und W enthalten sind, oder aus einem Silizid eines solchen Metalls.

10. Integrierte JK-Flipflop-Schaltung nach einem der Ansprüche 6 bis 8, d a d u r c h  g e k e n n - z e i c h n e t , daß die einen Teil der Kollektorschicht darstellende metallische oder metallisch leitende Schicht (22) aus einer hochdotierten III-V-Halbleiterverbindung, wie z.B. GaAs, besteht, die mit einer n-Dotierung versehen ist.

11. Integrierte JK-Flipflop-Schaltung nach einem der Ansprüche 1 bis 10, d a d u r c h  g e k e n n - z e i c h n e t , daß die Dicke der zwischen der Basisschicht (18) und dem Kanalbereich (19) befindlichen Isolatorschicht (20) und gegebenenfalls die Dicke der zweiten Isolatorschciht (21) etwa 2 bis 5 nm beträgt.

## FIG 1

## FIG 2

2/2

0135139

FIG 3

FIG 4